# FASCICULE DE BREVET EUROPEEN

(11) **EP 4 268 270 B1**
(45) Date de publication et mention de la délivrance du brevet: **08.01.2025**
(21) Numéro de dépôt: 21839592.9
(22) Date de dépôt: 23.12.2021
(51) Int. Cl.: H01L 21/321

(54) **PLANARISATION DE DIÉLECTRIQUE, LOCALISÉE ET BASSE TEMPÉRATURE**
PLANARISIERUNG VON DIELEKTRISCHEN SCHICHTEN BEI NIEDRIGEN TEMPERATUREN
LOCALIZED AND LOW TEMPERATURE PLANARIZATION OF DIELECTRIC

(30) Priorité: 23.12.2020 FR 2014023
(43) Date de publication de la demande: 01.11.2023
(73) Titulaire: THALES, 92190 Meudon (FR); Commissariat à l'Energie Atomique et aux Energies Alternatives, 75015 Paris (FR)
(72) Inventeur: QUINCHARD, Grégory, 91767 PALAISEAU Cedex (FR); MISMER, Colin, 91767 PALAISEAU Cedex (FR)
(74) Mandataire: Atout PI Laplace
(86) Numéro de dépôt international: PCT/EP2021/087541
(87) Numéro de publication internationale: WO 2022/136659

(56) Documents cités:
- US-A1- 2013 320 470
- US-A1- 2018 017 524
- YOON Y ET AL: "Planarization of Discrete Track Recording Media to Improve Flyability of Magnetic Recording Sliders", IEEE TRANSACTIONS ON MAGNETICS, IEEE SERVICE CENTER, NEW YORK, NY, US, vol. 45, no. 10, 1 October 2009 (2009-10-01), pages 3527 - 3530, XP011277284, ISSN: 0018-9464, DOI: 10.1109/TMAG.2009.2024764

## Description

### Champ d'application

L'invention concerne un sous-procédé de planarisation faisant partie d'un procédé global de fabrication microélectronique et/ou microtechnique permettant de réaliser une étape de planarisation localisée basée sur une structure en diélectrique supportant des contacts métalliques. Ces pistes métalliques relient des structures nivelées entres elles.

### Problème soulevé

Plusieurs techniques de fabrication ont été développées pour réaliser des microstructures et des nanostructures sur des substrats semi-conducteurs permettant de fabriquer des circuits et des systèmes intégrés. Ces systèmes couvrent une multitude d'usages tels que des circuits microélectroniques à base de transistors, des micro-systèmes de type MEMS (acronyme du terme anglais Micro-Electro-Mechanical Systems ) ou NEMS (acronyme du terme anglais Nano-Electro-Mechanical Systems), des capteurs intégrés (capteurs de pression, accéléromètres, capteurs chimiques ...), ou des systèmes photoniques et optoélectroniques intégrés sur un substrat semi-conducteur.

Plus spécifiquement, il est possible de réaliser des systèmes hybrides combinant deux domaines physiques. Les systèmes hybrides permettent d'associer deux fonctionnalités réalisées dans des matériaux différents. Il s'agit par exemple :
- d'un détecteur, dans lequel la partie sensible est associée à un circuit de lecture permettant de récolter et traiter le signal à détecter,
- d'un afficheur, par exemple de type électroluminescent, dans lequel la partie émettrice est associée avec un circuit de génération de signaux électriques adaptés à l'émission,
- d'un circuit photonique, avec des émetteurs lasers associés à des couches de traitement des faisceaux émis (guidage, multiplexage/démultiplexage, amplification ...), la/les couches de traitement étant déposées sur un substrat silicium (« Photonic on Silicon »),
- d'un circuit électronique avec des transistors rapides ou de puissance associés à un système de contrôle.

Les deux premiers systèmes hybrides peuvent être qualifiés d'optoélectroniques, le troisième peut être purement optique ou optoélectronique, tandis que le quatrième est purement électronique.

Sans perte de généralité, l'ensemble des techniques de fabrication utilisées dans les procédés pour les microtechnologies et nanotechnologies comprend les étapes technologiques suivantes :
- L'épitaxie : consistant en une technique de croissance d'une couche de matériaux sur un substrat composé d'un autre matériau.
- Le dopage : consistant en l'introduction d'impuretés à travers des atomes en petites quantités dans un réseau cristallin pur pour modifier sa conductivité électrique.
- Le traitement thermique : consistant à augmenter la température d'un substrat sous atmosphère contrôlée afin de changer ses propriétés.
- Le dépôt : consistant à déposer des couches fines de matériau sur la plaquette supportant le dispositif. Il peut être réalisé via un procédé chimique CVD (Chemical Vapor Déposition) ou un procédé physique PVD (Physical Vapor Déposition).
- La lithographie : une technique consistant à recouvrir la totalité de la surface de la plaquette par une résine. La résine, étant exposée à un faisceau à travers un masque, définit des motifs à l'image du masque ou à l'inverse du masque.
- La gravure, consistant en un procédé humide ou sec permettant d'enlever une matière déposée.
- La planarisation ou l'aplanissement : il s'agit d'un procédé permettant d'aplanir les reliefs sur les couches supérieures de la structure composée par différents matériaux. Cette étape est utilisée pour planariser ces couches afin de les préparer aux étapes lithographiques suivantes, évitant ainsi les problèmes de mise au point liés aux variations de profondeur lors de l'illumination de la résine photosensible.

L'invention concerne l'étape technologique de planarisation en proposant une technique alternative aux techniques de l'état de l'art et plus adaptée aux systèmes ayant des contraintes de température et nécessitant une planarisation localisée pour, par exemple, connecter des microstructures séparées par des surfaces présentant des reliefs positifs ou négatifs. On entend par reliefs des variations de la hauteur (ou de l'altitude) des plans supérieurs, en partant du substrat, des différentes structures appartenant au système en cours de fabrication.

Les techniques actuellement utilisées pour réaliser l'étape technologique de planarisation présentent plusieurs inconvénients qui affectent les performances du système intégré fabriqué. La réalisation de telles architectures nécessite la mise en oeuvre de plusieurs étapes technologiques induisant à chaque étape des budgets thermiques supplémentaires et ne permettant pas de planariser en une seule étape des objets de hauteurs différentes.

A titre d'exemple, le développement de nouveaux dispositifs plasmoniques pour le moyen-infrarouge (antennes optiques, résonateurs) couplés aux architectures traditionnelles (laser, détecteurs, modulateurs) amène de nouvelles perspectives technologiques mais impose également de revoir certaines méthodes de fabrication. Ces architectures optiques imposent des contraintes dans le choix des matériaux et de leur environnement.

En ce sens, plusieurs problèmes ont été clairement identifiés avec les techniques de fabrication usuelles de l'état de l'art. Les métaux privilégiés pour ces composants ont tendance à diffuser à travers les structures lors des traitements thermiques au cours du procédé de fabrication d'où l'intérêt de limiter le budget thermique pour atténuer ce phénomène de diffusion. De plus, les structures plasmoniques sont très sensibles à leur environnement d'un point de vue optique. Pour ne pas affecter les performances du système, il est souhaitable de limiter toute interaction optique entre les couches photodétectrices du composant et les interconnexions métalliques extérieures.

### Art antérieur/ Restrictions de l'état de l'art

Nous allons commencer par introduire les différentes techniques de planarisation connues par l'Homme de l'art.

La première technique est la technique de polissage mécano-chimique (CMP pour l'acronyme de l'expression en Anglais Chemical-Mechanical Planarization). Elle consiste à déposer une couche de matériau diélectrique sur l'intégralité de la surface de la plaquette (« wafer » en anglais) comprenant le système en cours de fabrication. La couche de diélectrique déposée couvre toutes les structures faisant partie du système. On utilise généralement du dioxyde de Silicium SiO2 ou du Nitrure de Silicium Si3N4 . Le niveau de la couche de diélectrique est ensuite abaissé et aplani via une combinaison de traitement chimique et mécanique (polissage) pour obtenir une surface lisse et uniforme. Le niveau de la surface obtenu suite à ce traitement doit être égal au niveau des surfaces supérieures des structures préalablement couvertes pour pouvoir les connecter en déposant des pistes métalliques, par exemple, sur la surface de la couche diélectrique aplanie par le procédé CMP. Les inconvénients de ce procédé sont les suivants :
- Traitement non-localisé : La technique de planarisation CMP nécessite le dépôt d'une couche de diélectrique sur la globalité de la surface de la plaquette couvrant ainsi toutes les structures même celles pour lesquelles la planarisation n'est pas nécessaire. Par ailleurs, ces dépôts sur plaque entière peuvent nuire aux performances de certains composants optiques dans l'exemple d'un dispositif optique ou optoélectronique. Un traitement de planarisation localisé et ciblé permettrait de minimiser les perturbations des autres structures non concernées par ce traitement, or ceci n'est pas possible avec la technique de planarisation CMP.
- Un haut budget thermique : Le dépôt de la couche de diélectrique sur la surface de la plaque supportant le dispositif implique un fort budget thermique avec une température supérieure à 180°C avec un temps variable selon l'épaisseur à déposer.
- Une complexité du procédé : Généralement, l'étape de planarisation par CMP est suivie par une étape de gravure pour enlever l'excèdent de matériau diélectrique déposé. Cela rajoute des étapes supplémentaires au procédé et complexifie alors le procédé de fabrication global.

La deuxième technique pour pouvoir connecter des microstructures ayant des altitudes différentes ou étant séparées par des surfaces présentant des reliefs est la fabrication des microstructures de connexion de type pont à air. Il s'agit d'une structure basée sur une piste métallique connectant les surfaces supérieures de deux microstructures en s'appuyant juste sur les points de contact de chaque bord. On parle ainsi d'un pont à air. Les inconvénients de ce procédé sont les suivants :
- Une fragilité mécanique : la piste métallique qui forme le pont ne repose que sur deux points d'appui ce qui présente une fragilité de la structure de connexion. Dans le cas d'une rupture mécanique, la connexion électrique entre les deux microstructures connectées sera perdue ce qui implique des dysfonctionnements du dispositif fabriqué.
- Un haut budget thermique : La fabrication de la structure pont à air fait appel à deux étapes de lithographie mettant en jeu une couche sacrificielle spécifique (résine PMGI). Cela requiert des recuits thermiques à un haut budget thermique allant jusqu'à trois minutes à une température de 190°C.

La troisième technique envisageable selon l'état de l'art est la croissance d'un support en matériau semi-conducteur par épitaxie. Les pistes de connexion métalliques sont ensuite déposées sur le support obtenu par épitaxie. Dans le cas d'un dispositif optique comprenant des éléments actifs à base de matériau semi-conducteur, cette technique présente l'inconvénient d'augmenter la génération de bruit et/ou de courant d'obscurité indésirable. De plus, cette technique nuit aux performances électromagnétiques d'un résonateur optique car la constante diélectrique d'un matériau semi-conducteur est plus élevée que celle des matériaux diélectriques.

La demande de brevet américaine US 2013/0320470 A1 décrit un dispositif photo détecteur comprenant une pluralité de résonateurs optiques. Le procédé de fabrication décrit par le brevet comprend une étape de planarisation réalisée par un dépôt global d'une couche de diélectrique sur toute la surface de la plaque. Il s'agit d'un traitement non-localisé avec un haut budget thermique.

La publication de *C. Maddalon et al.* et al, intitulée « Planarization properties of HSQ, influence on CMP» décrit une technique de planarisation de structures (lignes en Aluminium) par une résine comprenant l'hydrogène silsesquioxane (HSQ) . Dans la publication citée, la résine HSQ est étalée sur l'ensemble de la surface sans être insolée. L'inconvénient de la solution décrite par Maddalon est la nécessité d'ajouter des étapes supplémentaires de polissage CMP ou de gravure physique pour connecter des structures séparées par des reliefs ou ayant des hauteurs différentes.

La publication de *C. Choi, et al.* et al, intitulée « Planarization of patterned magnetic recording media to enable head flyability» décrit une technique de planarisation d'un dispositif magnétique. L'inconvénient de la solution décrite par cet article est de limiter la planarisation entre des structures ayant la même hauteur. Le document US2018/017524A1 et la publication YOON Y ET AL: "Planarization of Discrète Track Recording Media to Improve Flyability of Magnetic Recording Sliders",IEEE TRANSACTIONS ON MAGNETICS, IEEE SERVICE CENTER, NEW YORK, NY, US, vol. 45, no. 10, 1 octobre 2009 (2009-10-01), pages 3527-3530, XP011277284,ISSN: 0018-9464, DOI: 10.1109/TMAG.2009.2024764 sont pertinents pour la présente invention.

### Réponse au problème et apport solution

Pour pallier les limitations des solutions existantes en ce qui concerne la réalisation d'une étape technologique de planarisation permettant de connecter des microstructures ayant des hauteurs différentes ou séparées par des surfaces présentant des reliefs positifs ou négatifs, l'invention propose un procédé de planarisation localisée, versatile, simple et à bas budget thermique. Le procédé selon l'invention permet de fabriquer une microstructure de connexion comprenant un support en matériau diélectrique et une couche métallique reposant sur ledit support. Le procédé selon l'invention permet de fabriquer un support par l'insolation d'une résine via une lithographie. Plus particulièrement, l'application d'une lithographie à faisceau d'électrons sur une résine négative, inorganique et isolante électriquement comme l'hydrogène silsesquioxane HSQ permet de réaliser une planarisation (ou aplanissement) via un procédé plus adapté à la fabrication de dispositifs émergents dont la performance et la robustesse sont affectées par les techniques de planarisation usuelles présentant les inconvénients détaillés préalablement à savoir la non-localisation, le haut budget thermique, la complexité et la fragilité mécanique.

### Résumé /Revendications

L'invention a pour objet un procédé de fabrication d'un dispositif réalisé sur un substrat en un premier matériau semi-conducteur; le procédé de fabrication comprenant les étapes suivantes :
i- Fabriquer au moins une première microstructure et une deuxième microstructure sur le substrat,
ii- Fabriquer une microstructure de connexion permettant de connecter électriquement au moins la première microstructure à la deuxième microstructure en :
   - Déposant une couche d'une solution de résine inorganique répartie sur le substrat.
   - Chauffant le dispositif à une température de chauffe pendant une durée déterminée pour évaporer le solvant de la solution de résine déposée.
   - Fabriquant un support en matériau diélectrique en solidifiant, au moyen d'un procédé de lithographie, une partie de la couche de résine déposée ; le support comprenant au moins une première partie reliant la première microstructure et la deuxième microstructure.
   - Déposant une première couche métallique sur au moins une partie du support comprenant au moins ladite première partie reliant la première microstructure et la deuxième microstructure.

Selon un aspect particulier de l'invention, la résine déposée est une résine isolante électriquement et/ou négative.

Selon un aspect particulier de l'invention, la résine déposée est une résine électrosensible et l'étape de fabrication du support est réalisée par une lithographie à faisceau d'électrons.

Selon un aspect particulier de l'invention, la résine déposée est une résine HSQ comprenant de l'hydrogène silsesquioxane.

Selon un aspect particulier de l'invention, la résine déposée réagit à une insolation par faisceau d'électrons telle que l'épaisseur d'une partie solidifiée de la résine lors de l'étape de fabrication du support dépend de la dose énergétique reçue par la résine exposée au faisceau d'électrons. Le support comprend une deuxième partie présentant une surface avec une variation d'épaisseur graduelle réalisée en faisant varier la dose du faisceau d'électrons.

Selon un aspect particulier de l'invention, la première couche métallique (12) est déposée en outre sur la deuxième partie pour connecter une seconde couche métallique à une électrode ayant une hauteur différente de celle de la seconde couche métallique en partant du substrat.

Selon un aspect particulier de l'invention, la température de chauffe est inférieure à 100°C et la durée de chauffe est inférieure à 2 min.

Selon un aspect particulier de l'invention, la première microstructure et la deuxième microstructure sont des résonateurs optiques ; l'étape de fabrication i) comprend les sous-étapes suivantes :
i.1 assembler au substrat réalisé par le premier matériau semi-conducteur, un échantillon fabriqué préalablement comprenant une couche en un second matériau semi-conducteur reposant sur une couche métallique réflectrice, l'interface d'assemblage étant du côté de la couche métallique réflectrice.
i.2 déposer pour chacun des résonateurs une première couche métallique sur la couche du second matériau semi-conducteur.
i.3 graver sélectivement le second matériau semi-conducteur pour réaliser une structure photo-détectrice pour chacun des résonateurs ; la structure photo-détectrice étant confinée entre la couche métallique réflectrice et la première couche métallique.

L'invention a pour objet en outre un dispositif réalisé sur un substrat en un premier matériau semi-conducteur. Le dispositif comprend une première microstructure, une deuxième microstructure et une microstructure de connexion permettant de connecter électriquement la première microstructure et la deuxième microstructure. La microstructure de connexion comprend un support en matériau diélectrique et une couche métallique déposée sur ledit support. La surface couverte par le support est strictement inférieure à la surface du substrat.

Selon un aspect particulier de l'invention, le dispositif optoélectronique comprend au moins un pixel (Pxl). La première microstructure et la deuxième microstructure sont des résonateurs optiques appartenant à un même pixel et chaque résonateur optique comprend :
- une structure photo-détectrice réalisée en un second matériau semi-conducteur ou en un empilement d'une pluralité de couches en matériaux semi-conducteurs,
- une première couche métallique
- et une seconde couche métallique réflectrice (M2) ;

La structure photo-détectrice est confinée entre la première couche métallique et la seconde couche métallique réflectrice. Les deux résonateurs optiques sont connectés électriquement par la microstructure de connexion.

D'autres caractéristiques et avantages de la présente invention apparaîtront mieux à la lecture de la description qui suit en relation aux dessins annexés suivants.
[Fig. 1] la figure 1 illustre un schéma de deux résonateurs optiques intégrés dans un dispositif optoélectronique.
[Fig. 2] la figure 2 représente les étapes de fabrication d'un exemple d'une structure intermédiaire lors de la fabrication d'un dispositif optoélectronique nécessitant un sous-procédé de planarisation.
[Fig. 3] la figure 3 représente les sous-étapes pour réaliser l'étape technologique de dépôt de type « lift-off » pouvant être traduite par « dépôt à décollement » .
[Fig. 4] la figure 4 représente un mode de réalisation du procédé de fabrication comprenant des étapes de planarisation du dispositif optoélectronique de la figure 2 selon l'invention.
[Fig. 5a] la figure 5a représente une vue en coupe de deux résonateurs optiques connectés suite à l'exécution du procédé de planarisation selon l'invention.
[Fig. 5b] la figure 5b représente une vue de dessus de deux résonateurs optiques connectés suite à l'exécution du procédé de planarisation selon l'invention.
[Fig. 5c] la figure 5c représente une vue en perspective d'une partie du dispositif optoélectronique obtenu suite à l'exécution du procédé de planarisation selon l'invention.
[Fig. 6a] la figure 6a représente une vue de dessus d'un exemple d'un dispositif optoélectronique comprenant plusieurs pixels obtenus suite à l'exécution du procédé de planarisation selon l'invention.
[Fig. 6b] la figure 6b représente une vue de dessus d'un exemple d'un dispositif optoélectronique comprenant un unique pixel obtenu suite à l'exécution du procédé de planarisation selon l'invention.

L'invention propose un procédé de fabrication microélectronique et/ou microtechnique d'une structure hybride ou homogène permettant de réaliser une étape de planarisation localisée et à basse température basée sur une structure en diélectrique supportant des contacts métalliques.

Pour illustrer le procédé selon l'invention, nous allons décrire à titre d'exemple l'application de l'étape technologique de planarisation selon l'invention pour fabriquer un dispositif hybride optoélectronique. Plus particulièrement, il s'agit d'un détecteur infra-rouge comprenant une matrice de pixels composée d'au moins un pixel, chaque pixel comprenant une pluralité de résonateurs optiques connectés entre eux. Le dispositif détecteur infra-rouge décrit représente un système hybride car la matrice de pixels (composant la partie optique du système) est associée à un circuit de lecture intégré dans un substrat semi-conducteur (composant la partie électronique du système).

La description de la fabrication et de la structure de ce système est donnée à titre indicatif, et la technique de planarisation selon l'invention est compatible pour la fabrication d'autres structures dans le domaine de la microélectronique et la microtechnique d'une façon plus générale.

Une nouvelle génération de composants de type micro optique a récemment vu le jour, fondée sur une transposition en optique du phénomène de rayonnement d'une antenne, jusqu'ici mis en oeuvre pour le domaine hyperfréquence. Des résonateurs, d'une taille de l'ordre de grandeur de la longueur d'onde, typiquement des antennes plasmoniques, réémettent (rayonnent), à partir d'une onde incidente, une lumière présentant une longueur d'onde de résonance, par modification de la phase de l'onde incidente. Cette modification ne s'effectue pas au cours d'une propagation d'un rayon lumineux comme c'est le cas classiquement, mais de façon abrupte. On parle alors de « metasurface ». A noter que ce principe physique diffère de celui de l'indice effectif, dans lequel la phase est également imprimée au cours de la propagation le long d'un chemin optique par des éléments de dimension sous-longueur d'onde.

Un photon incident sur un point de la structure micro optique est capté par une nano antenne précise, interagit avec elle, et est réémis avec une phase donnée. Chaque nano antenne interagit avec l'onde incidente en lui imprimant une modulation de phase, et/ou d'amplitude, et/ou de polarisation. L'arrangement de ces résonateurs permet de modeler le front d'onde incident afin d'assurer la fonction optique souhaitée, ce qui ouvre un vaste champ d'ingénierie de front d'onde.

Le résonateur peut être de type MIM (Métal/lsolant/ Substrat Métal) ou plus généralement Conducteur/lsolant/Substrat fonctionnant en réflexion, ou de type diélectrique (sur substrat diélectrique), fonctionnant en réflexion ou en transmission.

Chaque résonateur est un dipôle rayonnant ou dipôle de Huygens (méta-surface de Huygens) et un nombre important de modes d'antenne sont accessibles en jouant sur la forme, la taille et l'agencement de ces dipôles.

Ce sont les interférences entre ces différents modes d'antenne (par exemple résonance dipolaire/quadripolaire électriques et magnétiques) qui sont ajustées pour être constructives vers l'avant et destructives vers l'arrière (fonctionnement en transmission), ou inversement constructives vers l'arrière et destructives vers l'avant (fonctionnement en réflexion). L'ingénierie de ces résonances et de leurs diagrammes de rayonnement confèrent un grand nombre de degrés de liberté pour le modelage (spatial et spectral) du front d'onde incident.

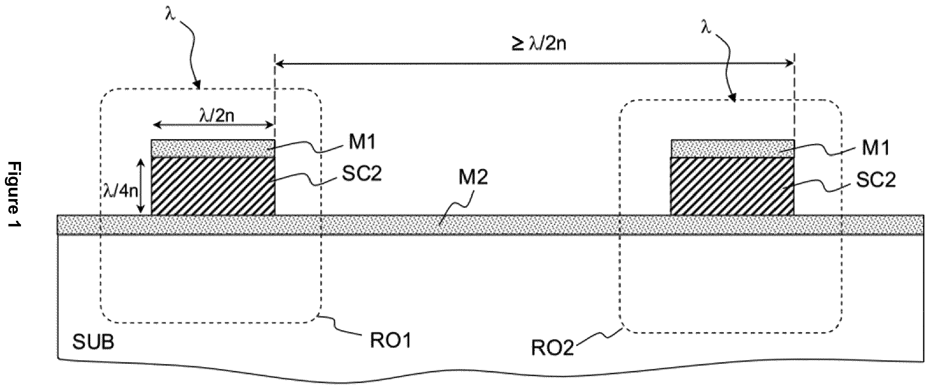

La figure 1 illustre un schéma de deux résonateurs optiques intégrés dans un exemple de dispositif optoélectronique obtenu par le procédé selon l'invention.

Les résonateurs optiques RO1 et RO2 présentés dans la figure 1 reposent sur un substrat SUB en matériau semi-conducteur. Nous nous limitons à ce stade à représenter le substrat SUB pour simplifier la représentation, mais le volume de la partie sur laquelle reposent les deux résonateurs RO1 et RO2 comprend généralement d'autres microstructures qui font partie de l'ensemble du dispositif hybride optoélectronique OPT. A titre d'exemple, l'ensemble des résonateurs composant la partie optique du dispositif hybride sont assemblés avec une plaquette (ou wafer en anglais) en silicium comprenant elle-même la partie électrique du dispositif à savoir un circuit microélectronique intégré pour la lecture des signaux engendrés par les porteurs de charges photo générés par les différents résonateurs.

Chaque résonateur optique RO1 ou RO2 comprend une structure photo-détectrice réalisée en un second matériau semi-conducteur SC2 et définissant une mesa, une première couche métallique M1 et une seconde couche métallique réflectrice M2. La structure en mesa photo-détectrice SC2 est confinée entre la seconde couche métallique réflectrice M2 et la première couche métallique M1.

On entend par « mesa » une microstructure ou nanostructure correspondant à un volume reposant sur un plan et ayant une surface supérieure plane.

Alternativement, il est possible de réaliser la structure photo-détectrice avec une hétéro-structure semi-conductrice présentant un gradient d'indice de réfraction.

La structure photo-détectrice SC2 joue le rôle d'une cavité photonique dans le résonateur optique RO1 (ou RO2). Cette structure est réalisée via un matériau de type III-V tel que, à titre d'exemple, l'arséniure de gallium, arséniure d'indium, nitrure de gallium, antimoniure de gallium, phosphure de bore. La couche (ou structure) photo détectrice SC2 repose sur la couche métallique réflectrice M2 jouant le rôle de miroir.

Alternativement, il est possible de réaliser la structure photo détectrice avec des alliages ternaires ou quaternaires ou quinaires ou une couche photo détectrice ayant un gradient de dopage N.

Alternativement, il est possible de réaliser la structure photo-détectrice d'un résonateur optique RO1 (ou RO2) avec un empilement d'une pluralité de couches composé de matériaux semi-conducteurs différents formant ainsi une hétéro-structure photo détectrice. Les matériaux semi-conducteurs utilisés pour la réalisation de l'empilement des couches de l'hétéro-structure photo détectrice sont de type III-V tels que, à titre d'exemple, l'arséniure de gallium, arséniure d'indium, nitrure de gallium, antimoniure de gallium, phosphure de bore. De plus, il est possible de réaliser l'hétéro-structure photo détectrice via des alliages ternaires ou quaternaires ou quinaires ou des couches photo détectrices ayant un gradient de dopage N.

Généralement, la couche réflectrice M2 est commune à tous les résonateurs optiques RO du dispositif hybride OPT étant connectée électriquement à la masse électrique du dispositif.

L'association de la couche métallique réflectrice M2 avec la première couche métallique supérieure M1 définit une nano-antenne sous-longueur d'onde pour un résonateur optique tel que décrit dans la figure 1. La couche métallique supérieure M1 est déposée sur la surface apparente de la mesa photo détectrice SC2. Le dimensionnement à l'échelle nanométrique du résonateur RO lui permet d'absorber des modes particuliers d'une onde incidente du côté de la couche supérieure de M1. L'onde incidente ayant une longueur d'onde λ est dans la gamme des longueurs d'ondes de l'infra-rouge ou du THz.

A titre indicatif, la couche réflectrice M2 et la couche supérieure M1 peuvent être réalisées avec de l'or (Au) ayant une épaisseur de couche variant, par exemple, entre 25nm et 500nm pour la couche réflectrice M2 et une épaisseur de couche variant, par exemple entre 150nm et 1000nm pour la couche supérieure M1.

Avantageusement, si on désigne par n l'indice de réfraction du matériau de la mésa photo détectrice SC2, le résonateur RE2 (ou RES3) est dimensionné de la manière suivante : au moins une dimension d'un résonateur (et donc de la couche supérieure M1 et de la structure photo détectrice SC2 ), choisie parmi la largeur ou la longueur, est comprise dans l'intervalle [λ/2n - 50% ; λ/2n + 50%]. L'épaisseur de la couche photo détectrice SC2 est inférieure à λ/2n . Par exemple, l'épaisseur de la couche photo détectrice SC2 peut être comprise dans l'intervalle [λ/4n - 50% ; λ/2n + 50%]. De plus, la distance séparant deux résonateurs optiques adjacents est supérieure à λ/2n.

De façon générale, il n'y a pas de limite maximale à l'épaisseur des couches métalliques utilisées hormis une contrainte d'épaisseur de la couche supérieure M1 liée à la diffraction. La limite basse de l'épaisseur est généralement définie par la profondeur de peau.

Ces intervalles de dimensionnement permettent de réaliser le fonctionnement de résonateur par les microstructures RO1 et RO2 décrites précédemment. En effet, chacun des résonateurs exalte le couplage lumière-matière entre le mode de cavité TM0 et la couche photosensible SC2, permettant d'exalter la réponse des technologies à faible efficacité quantique, comme les détecteurs inter-sous-bandes à puits quantiques (QWIPs et QCDs) ou les boites quantiques colloïdales II-VI (CQD).

Lorsque le résonateur RO est résonant, la lumière est alors guidée et concentrée dans la cavité photo-détectrice SC2, permettant de garantir une fonction de transfert de modulation (MTF) optimale, en diminuant (voir en supprimant complètement) les phénomènes de diaphonies (crosstalk en Anglais) optiques et électriques entre les résonateurs. Sachant que dans le dispositif hybride OPT, chaque pixel correspond à un ou plusieurs résonateurs connectés entre eux, la structure décrite par la figure 1 permet alors de réduire le pas pixel à sa dimension ultime correspondant à un pas sous-longueur d'onde. De plus, le volume effectif de semi-conducteur est beaucoup plus réduit que dans les dispositifs optoélectroniques planaires. Le volume électrique (celui de SC2, qui est notamment à l'origine du bruit) est beaucoup plus faible que le volume de collection des photons (à l'origine du signal). Ainsi, le courant et le bruit d'obscurité sont réduits dans le dispositif OPT comprenant des résonateurs RO1. Il en résulte une amélioration du rapport signal à bruit. Nous rajoutons que cette architecture est intrinsèquement rapide car elle présente une faible capacité du pixel.

Dans un mode de réalisation particulier, un résonateur optique RO fonctionne comme une antenne où la couche métallique inférieure M2 joue le rôle de couche réflectrice et la couche métallique supérieure M1 joue le rôle de l'élément rayonnant de l'antenne.

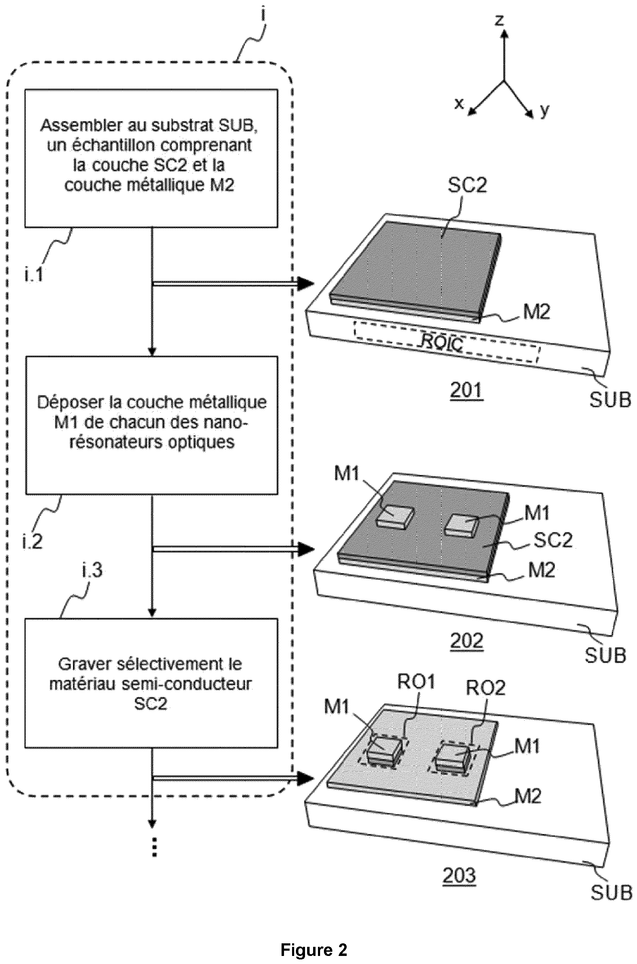

La figure 2 illustre les étapes de fabrication des résonateurs RO1 et RO2 décrits dans la figure 1 lors de la fabrication du dispositif optoélectronique OPT. Sans perte de généralité, et pour simplifier la présentation, nous nous limiterons à présenter les étapes de fabrication de deux résonateurs. Plus généralement, les étapes de fabrication illustrées par la figure 2 permettent de fabriquer N résonateurs optiques, avec N un entier strictement positif, selon les spécifications du dispositif optoélectronique OPT.

La première étape i.1 consiste à assembler un échantillon comprenant un second matériau semi-conducteur SC2 à la plaquette en silicium (présenté ici par substrat SUB). Nous nous limitons à ce stade à représenter le substrat SUB pour simplifier la représentation, mais le volume de la structure SUB comprend en outre en profondeur un circuit de lecture intégré ROIC dans la plaquette basée sur le substrat SUB. L'échantillon assemblé est fabriqué préalablement à cette étape et comprend une couche du matériau semi-conducteur utilisée pour les futures structures photo détectrices SC2 (de type III-V par exemple) reposant sur une couche conductrice métallique M2 (en Au par exemple). L'interface commune entre l'échantillon et le substrat SUB (contenant le circuit ROIC) est du côté de la surface apparente de la couche métallique M2. On obtient ainsi après l'étape d'assemblage i.1 la structure décrite dans la représentation en perspective 201 : en partant du bas vers le haut selon l'axe z on obtient le substrat SUB, puis la couche métallique M2 puis une couche en matériau semi-conducteur SC2.

L'assemblage peut être réalisé par collage, technique en plein développement et qui constitue un progrès important pour la réalisation d'étapes technologiques dites « above IC », c'est-à-dire d'étapes réalisables directement sur la plaque du circuit de lecture ROIC, typiquement de type CMOS, et de manière collective sur l'ensemble des puces. Cette compatibilité avec les moyens de fabrication CMOS est adaptée à une baisse significative des coûts de production et à la possibilité d'atteindre des motifs technologiques de taille plus fine.

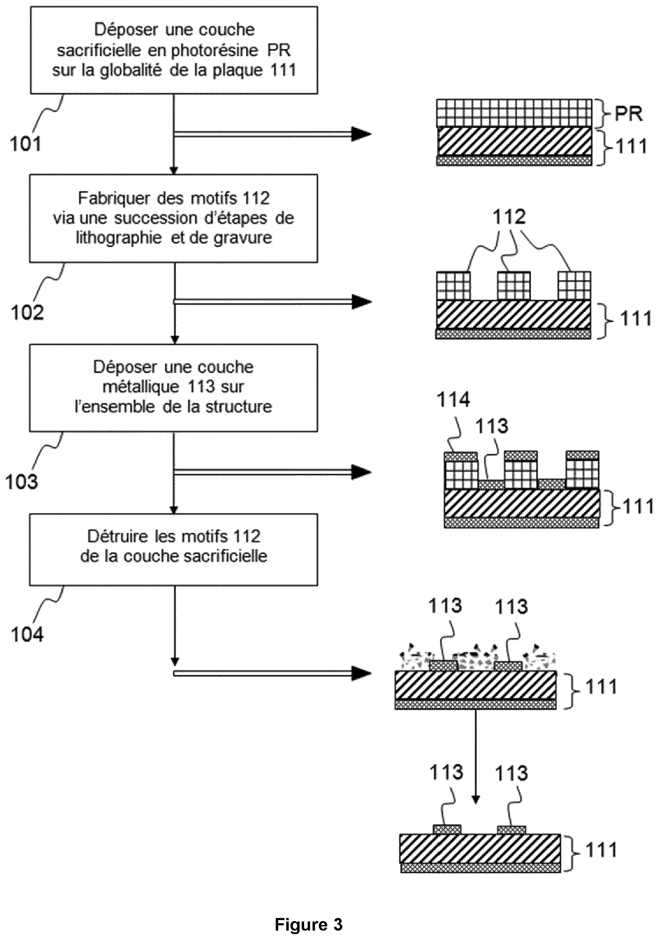

La deuxième étape i.2 consiste à déposer la couche métallique M1 de chacun des nano-résonateurs optiques RO1, RO2 pour former les structures métalliques supérieures M1 sur la couche du matériau semi-conducteur SC2. Cette étape est, par exemple, réalisée via un procédé de dépôt de type « lift-off » ou « dépôt à décollement » en français. Il s'agit d'une technique additive utilisée en microtechnique visant à créer des motifs d'un matériau cible (dans le cas présent, les couches métalliques M1) sur la surface d'un substrat (dans le cas présent, l'empilement des couches M2 et SC2) en utilisant un matériau sacrificiel (généralement une résine photosensible). A titre indicatif, le détail du déroulement d'un dépôt de type « lift-off » est décrit dans la figure 3.

La première sous-étape 101 d'un dépôt de type « lift off » consiste à déposer une couche sacrificielle en photorésine PR sur toute la plaque 111 qui comprend un empilement de couches. Ensuite, la deuxième sous-étape 102 consiste à fabriquer des motifs 112 dans la couche sacrificielle PR ia une succession d'étapes de lithographie et de gravure ou de révélation dans un solvant. La troisième sous-étape 103 consiste à déposer une couche métallique sur l'ensemble de la plaque 111 de façon à obtenir des couches métalliques 114 déposées sur les structures 112 mais aussi des couches 113 entre les structures 112 directement sur les surfaces apparentes de l'empilement de couches 111. La dernière sous-étape 104 consiste à détruire les motifs 112 par un procédé chimique permettant de garder seulement les couches métalliques 113 déposées directement sur l'empilement 111. Ainsi, la compilation des sous-étapes 101, 102, 103 et 104 permet de réaliser l'étape i.2 de dépôt de la couche métallique M1 de chacun des nano-résonateurs optiques RO1, RO2 sur la couche du matériau semi-conducteur SC2.

Le résultat de l'étape i.2 est illustré par la structure décrite dans la représentation en trois dimensions 202 où on peut observer les motifs carrés M1 déposés sur la couche en matériau semi-conducteur SC2.

La troisième étape i.3 consiste à graver sélectivement le matériau semi-conducteur SC2 pour garder seulement les parties couvertes par les motifs M1 déposés au cours de l'étape i.2. A titre d'exemple, cette étape peut être réalisée via une technique de gravure physique de type ICP (acronyme du terme Inductively Coupled Plasma). Il s'agit ici d'une technique de gravure sèche basée sur un système de torche à plasma.

Le résultat de l'étape i.3 est illustré par la structure décrite dans la représentation 203 : on obtient la structure des résonateurs optiques RO1 et RO2 comprenant chacun une mésa photosensible en matériau semi-conducteur SC2 (cavité du résonateur), une couche métallique supérieure M1 et une couche métallique réflectrice M2 (miroir du résonateur) commune à tous les résonateurs optique. L'ensemble des résonateurs compose la partie optique du système hybride assemblée avec la partie électronique consistant en un circuit de lecture ROIC intégré dans un substrat SUB en silicium. La partie optique (RO1, RO2) et la partie électronique (ROIC) assemblées, composent le dispositif hybride optoélectronique OPT.

Le dispositif optoélectronique OPT, comprend au moins un pixel Pxl à base des résonateurs préalablement décrits. Dans un mode de réalisation, un pixel Pxl comprend un seul résonateur tel que la couche métallique M1 est connectée à une électrode enterrée du circuit de lecture ROIC et la couche métallique réflectrice M2 commune à tous les pixels est connectée à la masse électrique.

Un inconvénient d'un pixel mono-résonateur réside dans la faible intensité de signal généré par le pixel ce qui peut créer des difficultés de détection. De plus, il est difficile de focaliser un faisceau incident infrarouge sur un seul résonateur.

Alternativement, il est possible de réaliser un pixel Pxl comprenant une pluralité de résonateurs permettant ainsi d'augmenter l'intensité du signal détecté en collectant l'intégralité du faisceau par un réseau de résonateurs. Ainsi, un pixel comprend une pluralité de résonateurs (RO1, RO2) telle que toutes les couches métalliques supérieures M1 de l'ensemble des résonateurs appartenant à un même pixel sont connectées entre elles.

Cela présente un défi technologique car les résonateurs fabriqués comme décrits préalablement sont séparés par des surfaces présentant des reliefs positifs ou négatifs et des différences de hauteurs. Cela rend l'étape technologique de planarisation nécessaire pour pouvoir déposer des pistes métalliques connectant les différentes couches M1 appartenant à un seul pixel Pxl.

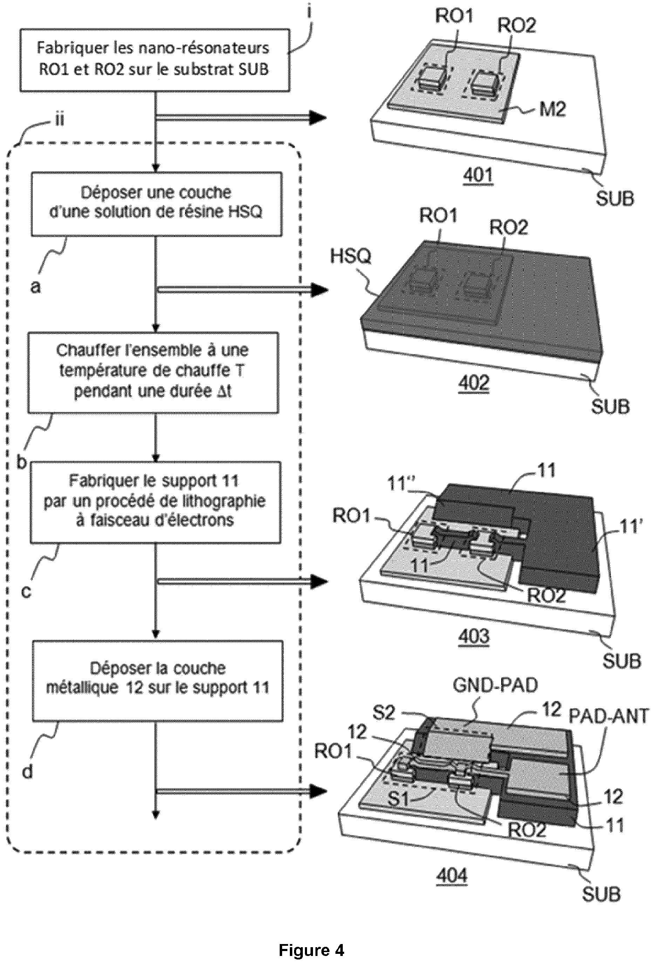

C'est dans ce cadre-là que se manifeste l'intérêt technique du procédé de planarisation selon l'invention illustrée par la figure 4. Ainsi, un objectif du procédé de fabrication selon l'invention présentée ci-dessous est la fabrication d'une microstructure de connexion permettant de connecter électriquement au moins une deuxième microstructure (dans ce cas le résonateur RO1) à une troisième microstructure (dans ce cas le résonateur RO2). Avant l'exécution des étapes de planarisation, la deuxième microstructure RO1 et la troisième microstructure RO2 sont séparées par au moins un relief positif ou négatif par rapport à l'une des microstructures à connecter.

La première étape i du procédé de fabrication microtechnique selon l'invention consiste à fabriquer les résonateurs sur le substrat SUB tel que détaillé précédemment. On obtient ainsi la structure illustrée dans 401.

La deuxième étape iia consiste à déposer une couche d'une solution de résine uniformément répartie sur le substrat semi-conducteur, par exemple, par un procédé d'enduction centrifuge (spin coating en Anglais). Avantageusement, et sans perte de généralité, la résine utilisée présente les caractéristiques suivantes :
- Electrosensible : pour pouvoir tracer les motifs voulus à l'aide d'une lithographie à faisceau d'électron permettant un traitement localisé et un contrôle de la hauteur des structures obtenues par insolation.
- Négative pour pouvoir tracer les motifs lors de l'insolation. Il est aussi possible d'envisager une résine positive bien que la lithographie soit beaucoup plus lente.
- Inorganique pour résister aux étapes technologiques suivantes du procédé de fabrication général impliquant des traitements chimiques utilisant des solvants. De plus, une résine inorganique est moins absorbante dans l'infrarouge qu'une résine organique. Cela permet de ne pas atténuer les performances des résonateurs optiques.
- Isolante électriquement pour éviter les risques de court-circuit.
- Versatile pour planariser des surfaces présentant des reliefs positifs ou négatifs. Cela permet son application sur une gamme variée de hauteurs d'objets en une seule étape et ainsi simplifier le procédé.

Une résine comprenant l'hydrogène silsesquioxane HSQ présente l'ensemble de ces caractéristiques.

En comparant la résine HSQ à la résine PMGI couramment utilisée pour la fabrication des ponts à air, nous constatons plusieurs avantages de la résine HSQ rendant son choix d'utilisation plus pertinent. En effet, la résine PMGI est organique, sa forme réticulée n'est pas solide mécaniquement et elle présente un fort taux d'absorption des rayons infrarouges atténuant les performances des résonateurs optiques.

Le procédé ne se limite pas à ce type de résine et d'autres résines inorganiques sont envisageables en adaptant le procédé avec les caractéristiques de la résine choisie. Par exemple, il est possible d'utiliser une résine photosensible dans le cas où une lithographie photonique est utilisée pour l'insolation.

La troisième étape iib consiste à effectuer un recuit thermique de l'ensemble de la structure couverte par la solution contenant la résine déposée pour évaporer le solvant. Cette étape nécessite un budget thermique très bas par rapport aux techniques de planarisation de l'état de l'art. En effet, l'étape de chauffe iib dans le procédé selon l'invention est réalisée à seulement 80°C pendant 1 minute pour le recuit pré-insolation. Cela présente un avantage considérable comparé aux techniques de planarisation de l'état de l'art comme le CMP nécessitant un traitement thermique à 180°C pendant quelques minutes.

La quatrième étape iic consiste à fabriquer le support en matériau diélectrique 11 via une opération de lithographie. En utilisant une résine HSQ, une lithographie à faisceau d'électrons permet une insolation localisée de la couche de HSQ. Sous l'action de l'exposition au faisceau d'électrons, la résine HSQ se réticule pour avoir une structure semblable à un diélectrique à l'état solide et plus particulièrement le dioxyde de silicium SiO2. Il est alors possible de tracer avec une précision nanométrique des motifs solides à partir de la couche de HSQ. L'association d'une résine HSQ à une lithographie à faisceau d'électrons présente en outre un avantage important. En contrôlant la dose d'exposition de la HSQ aux électrons, il est possible de faire varier son épaisseur après révélation. Cela permet d'ajuster localement la hauteur de support 11 pour s'adapter aux divers reliefs de l'échantillon. Suite à la phase d'insolation de la résine et la solidification des motifs qui forment le support 11, les parties de la résine déposée non-solidifiées sont enlevées de la surface de la plaquette pour garder uniquement les parties solides réticulées de la résine.

A titre indicatif, on obtient après l'étape iic la structure du support 11 illustrée dans 403. Dans le cas démonstratif de fabrication d'un dispositif optoélectronique OPT, la succession des étapes i à iic permet de fabriquer le support 11 reliant la couche M1 du résonateur optique RO1 à celle du résonateur optique RO2.

De plus, le support 11 comprend une couche 11' ayant la même hauteur que celle des couches supérieures M1 de RO1 et RO2 et reliée à la couche supérieure M1 de l'un quelconque des résonateurs optiques appartenant au même pixel. La surface supérieure de la couche 11' servira de support pour une électrode globale des résonateurs PAD_ANT.

De plus, le support 11 comprend une couche 11" présentant une surface dénivelée avec une altitude qui augmente graduellement à partir du niveau de la couche réflectrice M2 jusqu'à atteindre un plateau à une hauteur supérieure. Ledit plateau servira de support pour une électrode globale de la couche réflectrice notée GND_PAD.

L'étape suivante iid consiste à déposer la couche métallique 12 sur le support 11 pour connecter électriquement les couches supérieures M1 des résonateurs RO2 et RO1 mais aussi pour fabriquer l'électrode globale de masse GND_PAD connectée à la couche réflectrice M2 et fabriquer l'électrode globale antenne PAD_ANT connectée à une couche supérieure M1 d'au moins un des résonateurs optiques appartenant au pixel Pxl tel que présenté dans 404. Sans perte de généralité, l'étape iid peut être réalisée par une technique de dépôt de type « lift-off » décrite dans la figure 3.

Ainsi, le procédé décrit par la figure 4 permet de réaliser une planarisation présentant les avantages suivants par rapport aux techniques de l'état de l'art : versatile, localisée, à faible budget thermique, simple et permettant une liberté de conception selon les caractéristiques de la résine choisie.

Ce procédé est plus adapté à la fabrication de dispositifs émergents dont la performance et la robustesse sont affectées par les techniques de planarisation usuelles présentant les inconvénients détaillés préalablement à savoir la globalité de la planarisation, le haut budget thermique, la complexité et la fragilité mécanique.

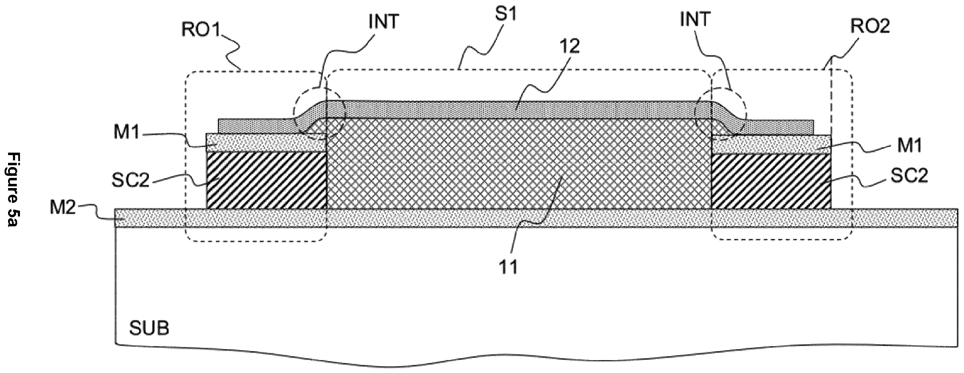

La figure 5a représente une vue en coupe des deux résonateurs RO1 et RO2 connectés par le procédé selon l'invention via la microstructure S1 résultante dudit procédé de planarisation. La microstructure de connexion S1 est composée par une partie du support 11 en matériau diélectrique (dans ce cas HSQ réticulée par faisceau d'électrons) et une partie de la couche 12 déposée lors de l'étape iid. La hauteur du support 11 dépasse de quelques dizaines de nanomètres la hauteur des résonateurs RO1 et RO2. Ce choix de conception permet de fabriquer une partie du support 11 qui couvre partiellement et d'une façon limitée la surface de chacune des couches supérieures M1 à connecter au niveau du bord adjacent au support 11 comme indiquée dans la figure 5a par la zone INT. Cela ajoute une robustesse mécanique et électrique à la microstructure S2 en renforçant les points de connexion avec les couches M1. Cette étape de micro-ingénierie nécessite une précision de fabrication qui n'est pas offerte par les solutions de l'état de l'art. Ce niveau de précision pour contrôler la hauteur du support 11 d'une façon localisée est assuré par modulation de la hauteur des motifs HSQ lors d'une insolation par un faisceau d'électrons.

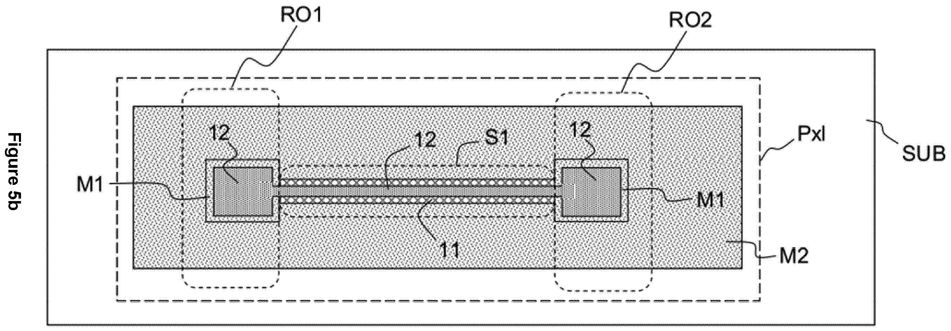

La figure 5b représente une vue de dessus d'un pixel Pxl comprenant deux résonateurs RO1 et RO2 connectés par le procédé selon l'invention via la microstructure S1 résultante dudit procédé de planarisation. La microstructure de connexion S1 est composée par une partie du support 11 en matériau diélectrique (dans ce cas HSQ réticulée par faisceau d'électrons) et une partie de la couche 12 déposée lors de l'étape v.

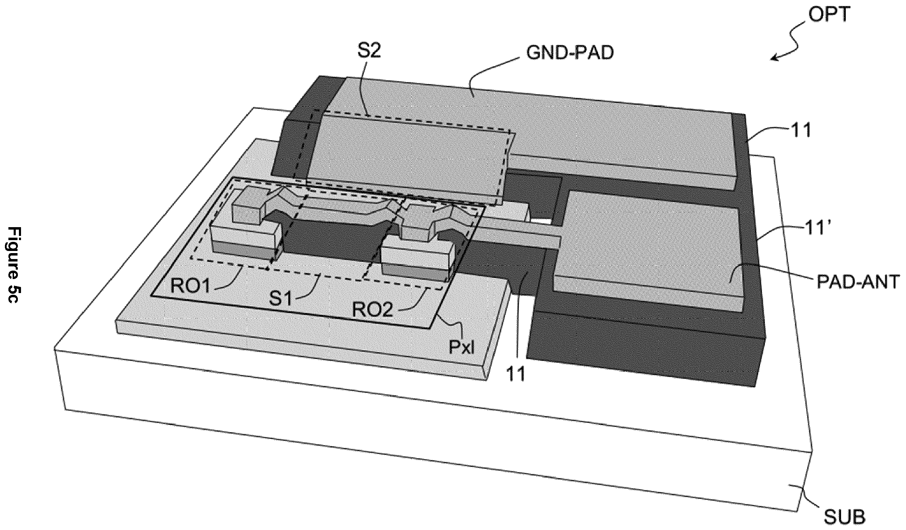

La figure 5c représente une vue en perspective d'une partie du dispositif optoélectronique OPT obtenu par le procédé selon l'invention. On observe le pixel Pxl composé des deux résonateurs RO1 et RO2 connectés via la microstructure S1. On illustre en outre l'électrode de masse globale GND_PAD connectée à la couche réflectrice M2 via une microstructure S2 présentant une surface avec une variation d'altitude graduelle. On illustre en outre l'électrode globale PAD_ANT reposant sur un plateau 11' du support 11 et connectée à au moins une des structures M1 du pixel Pxl.

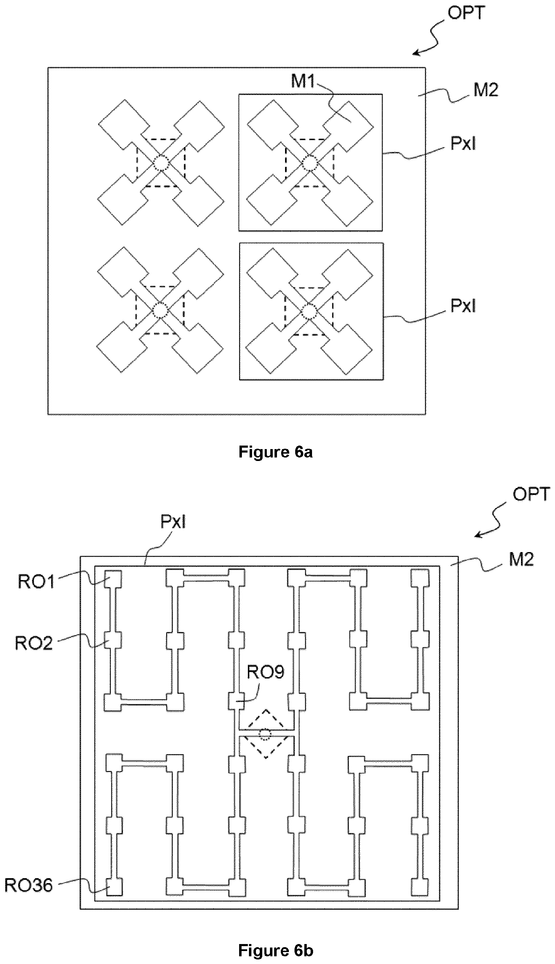

Les figures 6a et 6b illustrent des modes de réalisation alternatifs d'un dispositif optoélectronique OPT comprenant au moins un pixel Pxl. Dans la figure 6a, on illustre 4 pixels tels que chacun comprend 4 résonateurs optiques. Les quatre résonateurs sont connectés via une microstructure de connexion sous forme d'étoile réalisée par le procédé de fabrication selon l'invention. La figure 6b illustre un exemple de dispositif optoélectronique comprenant un seul pixel constitué de 36 résonateurs optiques connectés entre eux via une microstructure réalisée par le procédé de planarisation selon l'invention.

En guise de conclusion, l'invention décrite permet de réaliser un procédé de fabrication de la technologie d'un dispositif hybride réalisé sur un support composé d'un substrat comprenant un sous-procédé de planarisation permettant de connecter au moins deux structures séparées par une surface présentant au moins un relief négatif ou positif. Le procédé selon l'invention présente une alternative intéressante aux techniques de l'état de l'art tels que CMP ou le pont à air car il permet de réaliser une étape de planarisation localisée, à faible budget thermique et compatible avec les différents reliefs présents sur la surface à planariser.

## Revendications

1. Procédé de fabrication d'un dispositif (OPT) réalisé sur un substrat en un premier matériau semi-conducteur (SUB); le procédé de fabrication comprenant les étapes suivantes :
i- Fabriquer au moins une première microstructure (RO1) et une deuxième microstructure (RO2) sur le substrat (SUB),
ii- Fabriquer une microstructure de connexion (S1) permettant de connecter électriquement au moins la première microstructure (RO1) à la deuxième microstructure (RO2) en :
• Déposant une couche d'une solution de résine inorganique répartie sur le substrat (SUB).
• Chauffant le dispositif à une température de chauffe (T) pendant une durée déterminée (Δt) pour évaporer le solvant de la solution de résine déposée.
• Fabriquant un support (11) en matériau diélectrique en solidifiant, au moyen d'un procédé de lithographie, une partie de la couche de résine déposée ; le support (11) comprenant au moins une première partie reliant la première microstructure (RO1) et la deuxième microstructure (RO2).
• Déposant une première couche métallique (12) sur au moins une partie du support (11) comprenant au moins ladite première partie reliant la première microstructure (RO1) et la deuxième microstructure (RO2).

2. Procédé de fabrication d'un dispositif (OPT) selon la revendication 1 dans lequel la résine déposée est une résine isolante électriquement et/ou négative.

3. Procédé de fabrication d'un dispositif (OPT) selon la revendication 2 dans lequel la résine déposée est une résine électrosensible et dans lequel l'étape de fabrication du support (11) est réalisée par une lithographie à faisceau d'électrons.

4. Procédé de fabrication d'un dispositif (OPT) selon la revendication 3 dans lequel la résine déposée est une résine HSQ comprenant de l'hydrogène silsesquioxane.

5. Procédé de fabrication d'un dispositif (OPT) selon l'une quelconque des revendications 3 ou 4 dans lequel la résine déposée réagit à une insolation par faisceau d'électrons telle que l'épaisseur d'une partie solidifiée de la résine lors de l'étape de fabrication du support (11) dépend de la dose énergétique reçue par la résine exposée au faisceau d'électrons ;
et dans lequel le support (11) comprend une deuxième partie (11") présentant une surface avec une variation d'épaisseur graduelle réalisée en faisant varier la dose du faisceau d'électrons.

6. Procédé de fabrication d'un dispositif (OPT) selon la revendication 5 dans lequel la première couche métallique (12) est déposée en outre sur la deuxième partie (11") pour connecter une seconde couche métallique (M2) à une électrode (GND_PAD) ayant une hauteur différente de celle de la seconde couche métallique (M2) en partant du substrat (SUB).

7. Procédé de fabrication d'un dispositif (OPT) selon l'une quelconque des revendications précédentes dans lequel la température (T) de chauffe est inférieure à 100°C et la durée de chauffe (Δt) est inférieure à 2 min.

8. Procédé de fabrication d'un dispositif optoélectronique (OPT) selon une quelconque des revendications précédentes dans lequel la première microstructure (RO1) et la deuxième microstructure (RO2) sont des résonateurs optiques ; l'étape de fabrication i) comprend les sous-étapes suivantes :
i.1 assembler au substrat (SUB) réalisé par le premier matériau semi-conducteur, un échantillon fabriqué préalablement comprenant une couche en un second matériau semi-conducteur (SC2) reposant sur une couche métallique réflectrice (M2), l'interface d'assemblage étant du côté de la couche métallique réflectrice (M2).
i.2 déposer pour chacun des résonateurs (RO) une première couche métallique (M1) sur la couche du second matériau semi-conducteur (SC2).
i.3 graver sélectivement le second matériau semi-conducteur (SC2) pour réaliser une structure photo-détectrice pour chacun des résonateurs ; la structure photo-détectrice (SC2) étant confinée entre la couche métallique réflectrice (M2) et la première couche métallique (M1) .

9. Dispositif (OPT) réalisé sur un substrat en un premier matériau semi-conducteur (SUB); le dispositif (OPT) comprenant une première microstructure (RO1), une deuxième microstructure (RO2) et une microstructure de connexion (S1) permettant de connecter électriquement la première microstructure (RO1) et la deuxième microstructure (RO2) ; la microstructure de connexion (S1) comprenant
un support (11) en matériau diélectrique composé d'une résine inorganique solidifiée,
et une couche métallique (12) déposée sur ledit support. ;
la surface couverte par le support (11) étant strictement inférieure à la surface du substrat (SUB).

10. Dispositif optoélectronique (OPT) selon la revendication 9 comprenant au moins un pixel (Pxl) ; dans lequel la première microstructure (RO1) et la deuxième microstructure (RO2) sont des résonateurs optiques appartenant à un même pixel, chaque résonateur optique (RO1, RO2) comprenant une structure photo-détectrice réalisée en un second matériau semi-conducteur (SC2) ou en un empilement d'une pluralité de couches en matériaux semi-conducteurs, une première couche métallique (M1) et une seconde couche métallique réflectrice (M2) ; la structure photo-détectrice (SC2) étant confinée entre la première couche métallique (M1) et la seconde couche métallique réflectrice (M2) , les deux résonateurs optiques étant connectés électriquement par la microstructure de connexion (S1).

## Patentansprüche

1. Verfahren zur Herstellung einer Vorrichtung (OPT), die auf einem Substrat aus einem ersten Halbleitermaterial (SUB) erzeugt ist;
wobei das Herstellungsverfahren die folgenden Schritte umfasst:
i- Herstellen mindestens einer ersten Mikrostruktur (RO1) und einer zweiten Mikrostruktur (RO2) auf dem Substrat (SUB),
ii- Herstellen einer Verbindungsmikrostruktur (S1), die es ermöglicht, mindestens die erste Mikrostruktur (RO1) mit der zweiten Mikrostruktur (RO2) elektrisch zu verbinden, durch:
• Ablagern einer Schicht einer verteilten anorganischen Harzlösung auf dem Substrat (SUB).
• Erhitzen der Vorrichtung auf eine Heiztemperatur (T) über eine bestimmte Dauer (Δt), um das Lösungsmittel aus der abgelagerten Harzlösung zu verdunsten.
• Herstellen eines Trägers (11) aus dielektrischem Material durch Verfestigen eines Teils der abgelagerten Harzschicht mittels eines Lithografieverfahrens; wobei der Träger (11) mindestens einen ersten Teil umfasst, der die erste Mikrostruktur (RO1) und die zweite Mikrostruktur (RO2) verbindet.
• Ablagern einer ersten Metallschicht (12) auf mindestens einem Teil des Trägers (11), der mindestens den ersten Teil umfasst, der die erste Mikrostruktur (RO1) und die zweite Mikrostruktur (RO2) verbindet.

2. Verfahren zur Herstellung einer Vorrichtung (OPT) nach Anspruch 1, wobei das abgelagerte Harz ein elektrisch isolierendes und/oder negatives Harz ist.

3. Verfahren zur Herstellung einer Vorrichtung (OPT) nach Anspruch 2, wobei das abgelagerte Harz ein elektrosensitives Harz ist und wobei der Schritt der Herstellung des Trägers (11) durch Elektronenstrahllithographie durchgeführt wird.

4. Verfahren zur Herstellung einer Vorrichtung (OPT) nach Anspruch 3, wobei das abgelagerte Harz ein HSQ-Harz ist, das Wasserstoff-Silsesquioxan umfasst.

5. Verfahren zur Herstellung einer Vorrichtung (OPT) nach einem der Ansprüche 3 oder 4, wobei das abgelagerte Harz auf eine Elektronenstrahlbelichtung derart reagiert, dass die Dicke eines verfestigten Teils des Harzes während des Schritts der Herstellung des Trägers (11) von der Energiedosis abhängt, die das dem Elektronenstrahl ausgesetzte Harz erhält;
und wobei der Träger (11) einen zweiten Teil (11") umfasst, der eine Oberfläche mit einer progressiven Dickenänderung aufweist, die durch Ändern der Dosis des Elektronenstrahls erzeugt wird.

6. Verfahren zur Herstellung einer Vorrichtung (OPT) nach Anspruch 5, wobei die erste Metallschicht (12) ferner auf dem zweiten Teil (11") abgelagert wird, um eine zweite Metallschicht (M2) mit einer Elektrode (GND_PAD) zu verbinden, die eine unterschiedliche Höhe als die zweite Metallschicht (M2) aufweist, ausgehend von dem Substrat (SUB).

7. Verfahren zur Herstellung einer Vorrichtung (OPT) nach einem der vorhergehenden Ansprüche, wobei die Heiztemperatur (T) weniger als 100 °C beträgt und die Heizdauer ( Δt) weniger als 2 min. beträgt.

8. Verfahren zur Herstellung einer optoelektronischen Vorrichtung (OPT) nach einem der vorhergehenden Ansprüche, wobei die erste Mikrostruktur (RO1) und die zweite Mikrostruktur (RO2) optische Resonatoren sind; wobei der Herstellungsschritt i) die folgenden Teilschritte umfasst:
i.1 Zusammensetzen eines zuvor hergestellten Musters, das eine Schicht aus einem zweiten Halbleitermaterial (SC2) umfasst, die auf einer reflektierenden Metallschicht (M2) ruht, auf dem aus dem ersten Halbleitermaterial erzeugten Substrat (SUB), wobei sich die Zusammensetzungsschnittstelle auf der Seite der reflektierenden Metallschicht (M2) befindet.
i.2 Ablagern, für jeden der Resonatoren (RO), einer ersten Metallschicht (M1) auf der Schicht des zweiten Halbleitermaterials (SC2).
i.3 selektives Ätzen des zweiten Halbleitermaterials (SC2), um eine Photodetektorstruktur für jeden der Resonatoren zu erzeugen; wobei die Photodetektorstruktur (SC2) zwischen der reflektierenden Metallschicht (M2) und der ersten Metallschicht (M1) eingeschlossen ist.

9. Vorrichtung (OPT), die auf einem Substrat aus einem ersten Halbleitermaterial (SUB) erzeugt ist; wobei die Vorrichtung (OPT) eine erste Mikrostruktur (RO1), eine zweite Mikrostruktur (RO2) und eine Verbindungsmikrostruktur (S1) umfasst, die es ermöglicht, die erste Mikrostruktur (RO1) und die zweite Mikrostruktur (RO2) elektrisch zu verbinden;
wobei die Verbindungsmikrostruktur (S1) Folgendes umfasst:
einen Träger (11) aus einem dielektrischen Material, das aus einem verfestigten anorganischen Harz besteht,
und eine Metallschicht (12), die auf dem Träger abgelagert ist;
wobei die von dem Träger (11) bedeckte Fläche strikt kleiner als die Fläche des Substrats (SUB) ist.

10. Optoelektronische Vorrichtung (OPT) nach Anspruch 9, die mindestens ein Pixel (Pxl) umfasst; wobei die erste Mikrostruktur (RO1) und die zweite Mikrostruktur (RO2) optische Resonatoren sind, die zu demselben Pixel gehören, wobei jeder optische Resonator (RO1, RO2) eine Photodetektorstruktur, die aus einem zweiten Halbleitermaterial (SC2) oder aus einem Stapel aus einer Vielzahl von Schichten aus Halbleitermaterialien erzeugt ist, eine erste Metallschicht (M1) und eine zweite reflektierende Metallschicht (M2) umfasst; wobei die Photodetektorstruktur (SC2) zwischen der ersten Metallschicht (M1) und der zweiten reflektierenden Metallschicht (M2) eingeschlossen ist, wobei die beiden optischen Resonatoren durch die Verbindungsmikrostruktur (S1) elektrisch verbunden sind.

## Claims

1. A method for manufacturing a device (OPT) produced on a substrate in a first semiconductor material (SUB);
the manufacturing method comprising the following steps:
i- manufacturing at least one first microstructure (RO1) and one second microstructure (RO2) on the substrate (SUB),
ii- manufacturing a connection microstructure (S1) for electrically connecting at least the first microstructure (RO1) to the second microstructure (RO2) by:
• depositing a layer of an inorganic resin solution distributed over the substrate (SUB);
• heating the device to a heating temperature (T) for a determined time (Δt) to evaporate the solvent from the deposited resin solution;
• manufacturing a support (11) in a dielectric material by solidifying, by means of a lithography method, a part of the deposited resin layer; the support (11) comprising at least a first part linking the first microstructure (RO1) and the second microstructure (RO2);
• depositing a first metallic layer (12) on at least a part of the support (11) comprising at least said first part linking the first microstructure (RO1) and the second microstructure (RO2).

2. The method for manufacturing a device (OPT) according to claim 1, wherein the deposited resin is an electrically insulating and/or negative resin.

3. The method for manufacturing a device (OPT) according to claim 2, wherein the deposited resin is an electrosensitive resin and wherein the step of manufacturing the support (11) is performed by electron beam lithography.

4. The method for manufacturing a device (OPT) according to claim 3, wherein the deposited resin is an HSQ resin comprising hydrogen silsesquioxane.

5. The method for manufacturing a device (OPT) according to any one of claim 3 or 4, wherein the deposited resin reacts to electron beam insolation such that the thickness of a solidified part of the resin in the step of manufacturing the support (11) depends on the energy dose received by the resin exposed to the electron beam;
and wherein the support (11) comprises a second part (11") having a surface with a gradual thickness variation produced by varying the dose of the electron beam.

6. The method for manufacturing a device (OPT) according to claim 5, wherein the first metallic layer (12) is further deposited on the second part (11") to connect a second metallic layer (M2) to an electrode (GND_PAD) having a height that is different from that of the second metallic layer (M2), starting from the substrate (SUB).

7. The method for manufacturing a device (OPT) according to any one of the preceding claims, wherein the heating temperature (T) is less than 100 °C and the heating time (Δt) is less than 2 min.

8. The method for manufacturing an optoelectronic device (OPT) according to any one of the preceding claims, wherein the first microstructure (RO1) and the second microstructure (RO2) are optical resonators; the manufacturing step i) comprises the following substeps:
i.1 assembling, on the substrate (SUB) produced by the first semiconductor material, a previously manufactured sample comprising a layer made of a second semiconductor material (SC2) resting on a reflective metallic layer (M2), the assembly interface being on the side of the reflective metallic layer (M2);
i.2 depositing, for each of the resonators (RO), a first metallic layer (M1) on the layer of the second semiconductor material (SC2);
i.3 selectively etching the second semiconductor material (SC2) to produce a photo-detector structure for each of the resonators; the photo-detector structure (SC2) being contained between the reflective metallic layer (M2) and the first metallic layer (M1).

9. A device (OPT) produced on a substrate in a first semiconductor material (SUB), the device (OPT) comprising a first microstructure (RO1), a second microstructure (RO2) and a connection microstructure (S1) for electrically connecting the first microstructure (RO1) and the second microstructure (RO2);
the connection microstructure (S1) comprising
a support (11) made of a dielectric material composed of a solidified inorganic resin, and a metallic layer (12) deposited on said support;
the surface covered by the support (11) being strictly less than the surface of the substrate (SUB).

10. The optoelectronic device (OPT) according to claim 9, comprising at least one pixel (Pxl); wherein the first microstructure (RO1) and the second micro-structure (RO2) are optical resonators belonging to a same pixel, each optical resonator (RO1, RO2) comprising a photodetector structure produced in a second semiconductor material (SC2) or in a stack of a plurality of layers made of semiconductor materials, a first metallic layer (M1) and a second, reflective metallic layer (M2); the photodetector structure (SC2) being contained between the first metallic layer (M1) and the second, reflective metallic layer (M2), the two optical resonators being electrically connected by the connection microstructure (S1).
